# EUROPEAN PATENT APPLICATION

(11) **EP 1 743 961 A1**
(43) Date of publication of application: **17.01.2007**
(21) Application number: 05719126.4
(22) Date of filing: 15.02.2005
(51) Int. Cl.: C30B 29/40, H01L 21/205

(54) **COMPOUND SEMICONDUCTOR SUBSTRATE**

(30) Priority: 19.03.2004 JP 2004079504
(71) Applicant: Nippon Mining & Metals Co., Ltd., Minato-ku Tokyo 105-8407 (JP)
(72) Inventor: SUZUKI, Kenji c/o NIPPON MINING &METALS CO,LTD, Kitaibaraki-shi, Ibaraki 3191535 (JP); HIRANO, Ryuichi c/o NIKKO MATERIALS CO., LTD., Kitaibaraki-shi, Ibaraki 3191535 (JP); NAKAMURA, Masashi c/oNIPPON MINING &METALS CO,LTD, Toda-shi, Saitama 3358502 (JP)
(74) Representative: Jones, Helen M.M.
(86) International application number: PCT/JP2005/002224
(87) International publication number: WO 2005/090650

(57) **Abstract**

It is to provide a substrate for epitaxial growth, which is capable of improving a surface state of an epitaxial layer at microroughness level. In a substrate for epitaxial growth, when haze is defined as a value calculated by dividing intensity of scattered light obtained when light is incident from a predetermined light source onto a surface of a substrate, by intensity of the incident light from the light source, the haze is not more than 2 ppm all over an effectively used area of the substrate and an off-angle with respect to a plane direction is 0.05 to 0.10°.

## Description

### Technical Field

The present invention relates to a growth substrate for performing a vapor phase growth of a compound semiconductor layer, and specifically, relates to a technology of growing a compound semiconductor layer having good surface morphology and a surface microroughness of not more than a predetermined value.

### Background Art

In applications of semiconductor devices such as light emitting devices and light receiving devices, a semiconductor wafer having a group III-V compound semiconductor layer, such as InP or the like, epitaxially grown on an InP substrate has hitherto been widely used. The epitaxial layer of the compound semiconductor is formed by, for example, metal organic chemical vapor deposition (hereinafter, referred to as MOCVD).

When the aforementioned group III-V compound semiconductor layer is epitaxially grown by such MOCVD, there is a problem that protruding microdefects called hillocks and wrinkle-like defects called orange peel occur in the surface of the epitaxial layer, thus degrading the surface morphology of the epitaxial layer. Accordingly, various technologies have been proposed to improve the surface morphology of the epitaxial layer.

For example, Patent Literature 1 proposes a method in which the epitaxial growth is carried out under the condition that the substrate temperature is not less than 600°C and not more than 700°C using a wafer having a plane direction tilted at an angle of 0.1 to 0.2° with respect to the direction <100>, as the substrate for epitaxial growth by MOCVD. This method is successful in considerably reducing the hillocks (referred to as tear-shaped defects in the Patent Literature 1) in the surface of the epitaxial layer.

Moreover, Patent Literature 2 proposes an epitaxial growth method in which, in order to prevent the orange peel from occurring when tilt angle of the plane direction (referred to as off-angle) of the substrate is large, a range of the off-angle of the substrate is prescribed by a function of growth rate and substrate temperature. Such a proposition can considerably reduce the hillocks occurring in the surface of the epitaxial layer and is successful in preventing the orange peel from occurring.

Patent Literature 3 proposes a method in which the off-angle of the substrate is prescribed in consideration of defect density (dislocation density) of the substrate. Specifically, in vapor phase epitaxial growth of a thin layer of a compound semiconductor on the InP substrate, a substrate having off-angle θ (°) which satisfies θ >= 1×10⁻³D^{1/2} (D (cm⁻²) :defect density of the substrate) is used. For example, a substrate in which the off-angle satisfies θ >= 0.03 is used when the defect density D of the substrate is 1000 cm⁻², and a substrate in which the off-angle satisfies θ >= 0.10 when the defect density D of the substrate is 10000 cm⁻².
Patent Literature 1: Japanese Patent Publication No. 1975143
Patent Literature 2: Japanese Patent Publication No. 2750331
Patent Literature 3: Japanese Patent Publication No. 3129112

### Disclosure of the Invention

As described above, by using a semiconductor substrate in which the off-angle and dislocation density are prescribed and carrying out vapor phase growth under the predetermined growth conditions, it has been possible to grow an epitaxial layer having good surface morphology which can be used for industrial applications.

On the other hand, as semiconductor devices are required to be more highly integrated and more highly sophisticated, the quality of the surface state of the epitaxial layer is increasingly taken more seriously, and it is thought necessary to evaluate the surface state more accurately and in more detail. For example, the surface morphology including the aforementioned tear-shaped defects is observed by a Normarski microscope or the like, but it is thought desirable that the epitaxial layer is evaluated including a surface state which cannot be observed by such a method. In other words, even when there is no defects which can be observed by the aforementioned Normarski microscope in the surface of the epitaxial layer, the surface of the epitaxial layer is not completely smooth and includes at least roughness of micro-scale level (hereinafter, referred to as microroughness). Accordingly, it is desirable that the surface state of the epitaxial layer be evaluated taking such microroughness into consideration.

The present invention focuses on the microroughness in the surface of the epitaxial layer, which has not hitherto been seriously taken, and an object of the present invention is to provide a technology capable of improving the surface state of the epitaxial layer at the microroughness level.

### Means for Solving the Problem

In a conventional manufacturing process of a semiconductor wafer, a work of checking defects such as foreign substances adhering to the wafer surface has been conducted. Generally, for such defect check on the wafer surface, a surface foreign substance checking apparatus which irradiates the wafer surface with a laser beam and detects scattered light by an optical detector is used. A representative example thereof is Surfscan 6220 made by KLA-Tencor Corporation.

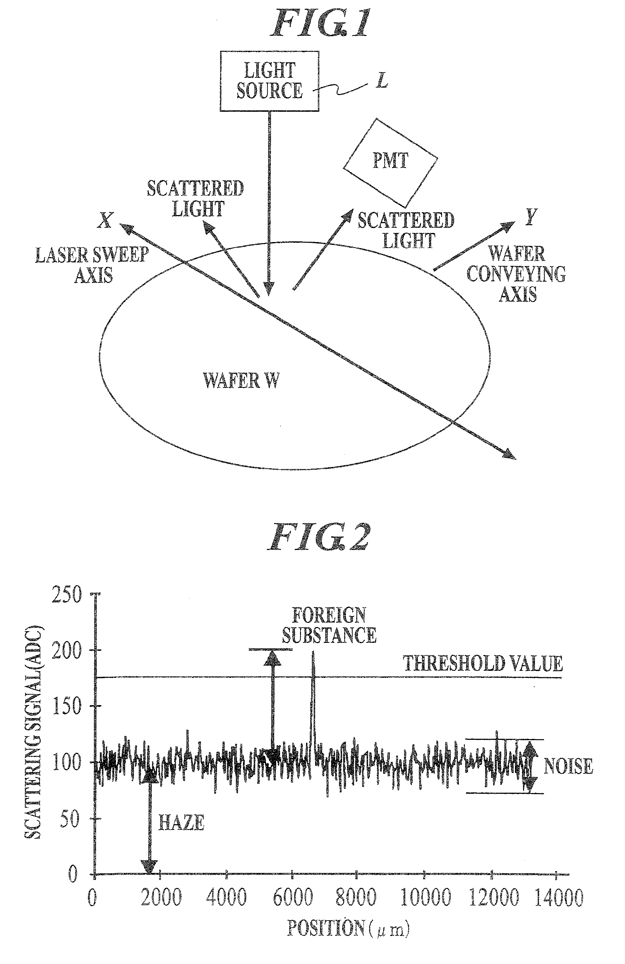

FIG. 1 shows a principle view of the Surfscan 6220. In the Surfscan 6220, a laser beam is irradiated from a light source L onto a wafer placed at a predetermined position. Depending on the surface state of the substrate, the light is scattered from the incident point, and the scattered light is collected and amplified by a low-noise photo-multiplier tube (PMT). The surface state of the wafer is then analyzed based on the scattering signal amplified by the PMT. Moreover, the laser beam is irradiated while the wafer is conveyed at a certain speed in a wafer conveying axis direction Y and the predetermined light source is reciprocated in a laser sweep axis direction X, thus sampling the entire substrate.

FIG. 2 shows the scattering signal from the wafer surface when scanning is performed with the light source L in the laser sweep axis direction X. As shown in FIG. 2, a part where the scattering signal is not less than a set threshold value is detected as a foreign substance. In addition to thus detecting foreign substances according to intensity of the scattering signal, the Surfscan 6220 can measure haze which is defined as a value obtained by dividing height of the background of the scattering signal (scattering light intensity) by incident light intensity (scattering light intensity/incident light intensity (ppm)) and evaluate the microroughness of the wafer surface according to the haze. For example, larger haze indicates larger microroughness in the wafer surface, thus indicating a bad surface state.

Herein, considering the surface of the epitaxial layer, when the surface of the epitaxial layer includes faults such as the tear-shaped defects, the roughness of the surface is certainly large, and the haze in the surface of the epitaxial layer is expected to be large accordingly. Moreover, even when there is no abnormal surface morphology, including the tear-shaped defects, observed in the surface of the epitaxial layer, the microroughness inversely affecting the performance of the semiconductor device could be included. In such a case, the surface of the epitaxial layer can be evaluated at the microroughness level by measuring the haze in the surface.

Based on the fact that the surface state of the epitaxial layer was required to be further improved in quality as semiconductor devices were more highly integrated and highly sophisticated, the inventors and the like focused on the microroughness of the surface of the epitaxial layer and, specifically, aimed to realize a haze of not more than 2 ppm in the surface of the epitaxial layer. This is because when the haze is not more than 2 ppm, the microroughness can be expected to be extremely small, and it can be certainly considered that the surface defects do not occur.

Specifically, the inventors first thought that the microroughness of the surface of the substrate for epitaxial growth had no small effect on the surface state (especially microroughness) of the epitaxial layer grown on the substrate and examined the relationship between the haze in the surface of the substrate before epitaxial growth and the haze in the surface of the epitaxial layer grown on the substrate. Herein, the haze was measured by the aforementioned Surfscan 6220 and expressed as a value in parts per million obtained by dividing the scattered light intensity by the incident light intensity. The haze in the surface of the epitaxial layer thus turned out to be always equal to or larger than the haze in the surface of the substrate used. This revealed that it was necessary to use a substrate in which the haze in the surface was as small as possible in order to reduce the microroughness in the surface of the epitaxial layer.

Moreover, when the epitaxial layers were grown on substrates with haze of 2 ppm or less, the haze in the surfaces of some epitaxial layers was about 2 ppm while that of some epitaxial layers was significantly degraded. More experiments were therefore made, and it was found that the haze in the surface of the epitaxial layer depended on not only the haze in the surface of the substrate but also the off-angle of the substrate. Specifically, when substrates with haze of not more than 2 ppm and off-angles of 0.05 to 0.10° were used, the haze in the surface of the epitaxial layer grown on each substrate could be not more than 2 ppm. Especially when substrates with haze of 0.5 to 0.8 ppm and off-angles of 0.06 to 0.10° were used, the haze in the surface of each epitaxial layer could be not more than 1 ppm.

The present invention was completed based on the above knowledge and was configured to prescribe the haze and off-angle of the surface of the substrate used for epitaxial growth in order to improve the surface state of the epitaxial layer at the microroughness level.

Specifically, in a substrate for epitaxial growth, when haze is defined as a value calculated by dividing intensity of scattered light obtained when light is incident from a predetermined light source onto a surface of a substrate, by intensity of the incident light from the light source, the haze is not more than 2 ppm all over an effectively used area of the substrate and an off-angle with respect to a plane direction is 0.05 to 0.10°. Desirably, the haze in the surface of the substrate is not more than 1 ppm. This can further reduce the haze in the surface of the epitaxial layer grown on the substrate. Herein, the haze is a value measured all over the effectively used area of the substrate (except peripheral part of the substrate including chamfered part) by use of, for example, Surfscan 6220 made by KLA-Tencor Corporation.

The present invention is effective especially when the compound semiconductor substrate is an InP substrate. Moreover, when the dislocation density is not more than 1000/cm², more desirably, not more than 500/cm² it is possible to effectively prevent the surface defects from occurring after epitaxial growth and the haze can be not more than 2 ppm.

### Effect of the Invention

When epitaxial growth is carried out using the substrate according to the present invention, the haze in the surface of the grown epitaxial layer is not more than 2 ppm. It is therefore possible to grow an epitaxial layer having an extremely good surface state with very small microroughness. Accordingly, a semiconductor device in which a semiconductor layer is epitaxially grown on the substrate according to the present invention can be applied to applications of semiconductor devices required to be highly integrated and highly sophisticated.

### Brief Description of Drawings

[FIG. 1] This is a principle view of surfscan 6220 made by KLA-Tencor corporation.
[FIG. 2] This shows an example of a scattering signal from a wafer surface when scanning with a light source L is performed in a laser sweep axis direction X.
[FIG. 3] This is a graph showing a relation between off-angle of a substrate and haze in a surface of an n-InGaAs layer grown on the substrate.
[FIG. 4] This is a graph showing a relation between off-angle of a substrate and haze in a surface of an InGaAs layer grown on the substrate.
[FIG. 5] This is a graph showing a relation between the haze in the surface of the InGaAs layer and sheet resistance.

### Explanation of Reference Numerals

L: light source
X: laser sweep axis
Y: wafer conveying axis
W: wafer
PMT: low-noise photo-multiplier tube

### Best Mode for Carrying Out the Invention

Hereinafter, a description is given of an embodiment of the present invention based on the drawings.

### Example 1

As Example 1, a description is given of a case where an epitaxial layer is grown on a substrate by metal organic chemical vapor deposition (MOCVD).
First, (100) InP single crystal with a dislocation density of not more than 1000 /cm² was produced by liquid encapsulated Czochralski (LEC), and the InP single crystal was cut into substrates for epitaxial growth. Surfaces of the InP single crystal substrates were subjected to mirror polishing by a usual method, thus preparing substrates with off-angles of 0.05 to 0.10° with respect to the direction <100>.

The aforementioned substrates were measured in terms of haze in the surfaces by the Surfscan 6220, and ones with haze of 0.5 to 0.8 ppm in a measurable area (effectively used area) were selected. The light source of the Surfscan 6220 was a 30 mW argon-ion laser with a wavelength of 488 nm.

On each of these substrates, an n-InP layer (thickness: 1.0 µm), an n-InGaAs layer (thickness: 4.0 µm), an n-InP layer (thickness: 2.0 µm), and an n-InGaAs layer (thickness: 0.1 µm) were sequentially grown by MOCVD. At this time, the growth rate of the epitaxial layer was set to about 1 µm/hour, and growth temperature was set to 620°C.

According to observation of the surface state of each epitaxially-grown n-InGaAs layer in the uppermost layer by a Normanski microscope, there was no surface defects observed, and it could be verified that the surface state was extremely good.

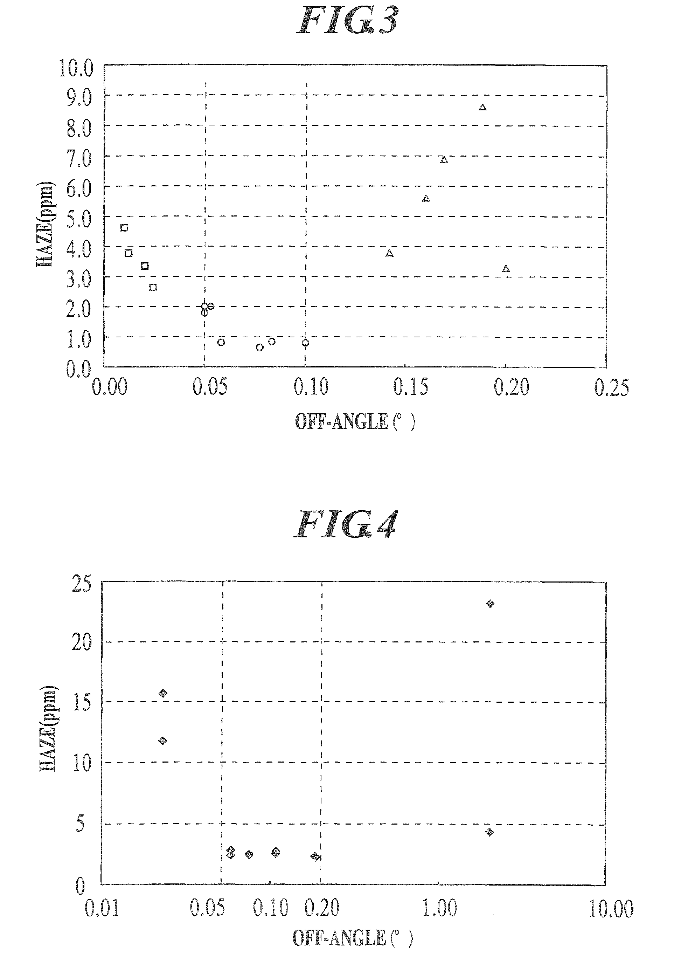

Moreover, the haze in the surfaces of the n-InGaAs layers was measured by the Surfacscan 6220. FIG. 3 shows a relation between the off-angle of the substrate and the haze in the surface of the n-InGaAs layer. The measurement results related to this embodiment are indicated by circles. As shown in FIG. 3, in the case of using the substrates with off-angles of 0.05 to 0.10°, the haze in the surface of each n-InGaAs layer was not more than 2 ppm. It could be thus verified that the epitaxial layer had an extremely good surface state with minimum microroughness. Especially in the substrates with off-angles of 0.06 to 0.10°, the haze in the surface of each substrate was comparable with the haze of the respective n-InGaAs layer, and degradation in microroughness could be effectively prevented.

On the other hand, the substrate state of the epitaxial layer in the case of using a substrate with an off-angle different from that of Embodiment 1 was evaluated for comparison. Specifically, InP substrates with a dislocation density of not more than 1000 /cm² were produced by LEC, and surfaces thereof were subjected to mirror polishing by a usual method, thus preparing substrates whose off-angles with respect to the direction <100> were less than 0.05° (0.01 to 0.025°) and substrates whose off-angles were more than 0.10° (0.14 to 0.20°). Subsequently, these substrates were measured in terms of the haze in the surfaces thereof by the Surfscan 6220, and ones whose haze in the measurable area was 0.5 to 0.8 ppm were selected. On these selected substrates, epitaxial layers of the same structure as that of the aforementioned embodiment were grown.

According to observation of the surface state of each epitaxially-grown n-InGaAs layer in the uppermost layer by a Normanski microscope, the surface morphology was degraded in the n-InGaAs layer grown on the substrate with an off-angle of 0.20°.

Moreover, the haze in the surfaces of the n-InGaAs layers was measured by the Surfscan 6220. The relation between the off-angle of the substrate and the haze in the surface of the n-InGaAs layer is shown in FIG. 3. The measurement results of the case of using the substrates with off-angles less than 0.05° were indicated by squares, and the measurement results of the case of using the substrates with off-angles more than 0.10° were indicated by triangles.

As shown in FIG. 3, in the case of using the substrates with off-angles less than 0.05°, the haze in the surfaces of the n-InGaAs layers was not less than 2 ppm, and the microroughness was observed to be degraded. Also in the case of using the substrates with off-angles more than 0.10°, the haze in the surfaces of the n-InGaAs layers was not less than 3 ppm, which shows that the microroughness was considerably degraded compared to the case of using the substrates with off-angles less than 0.05°.

As described above, by using a substrate in which the haze in the surface is not more than 1 ppm and the off-angle is 0.05 to 0.10°, the haze in the surface becomes not more than 2 ppm in the epitaxial layer grown on the substrate, and a good surface state can be realized. Moreover, it is obvious that surface defects such as the tear-shaped defects do not occur.

Moreover, in the aforementioned embodiment, the epitaxial growth was carried out using the substrates with haze of 0.5 to 0.8 ppm, that is, not more than 1 ppm. However, even when a substrate with a haze of not more than 2 ppm is used, the haze in the surface of the epitaxial layer grown on the substrate can be not more than 2 ppm based on the relation between the haze and off-angle of the substrate. Specifically, in a substrate with an off-angle of 0.06 to 0.10°, the haze in the surface of the substrate and the haze in the surface of the epitaxial layer were comparable, and there was no degradation observed in the microroughness. Accordingly, using a substrate with a haze of not more than 2 ppm can reduce the haze in the surface of the epitaxial layer to a predetermined value.

### Example 2

As Example 2, a description is given of a case where an epitaxial layer is grown on a substrate by molecular beam epitaxy (MBE).
First, (100) InP single crystal with a dislocation density of not more 1000 /cm² was produced by liquid encapsulated Czochralski (LEC), and the InP single crystal was cut into substrates for epitaxial growth. Surfaces of the InP single crystal substrates were subjected to mirror polishing by a usual method, thus preparing substrates with off-angles of 0.02 to 2.00° with respect to the direction <100>.

The aforementioned substrates were measured in terms of haze in the surfaces by the Surfscan 6220, and ones whose haze was not more than 2 ppm in the measurable areas (effectively used areas) were selected. The light source of the Surfscan 6220 was a 30 mW argon-ion laser with a wavelength of 488 nm.

On each of these substrates, molecular beams of In, Al, and As or molecular beams of In, Ga, and As were irradiated to grow an epitaxial layer of a HEMT structure composed of InAlAs/InGaAs with a thickness of 250 nm by MBE. At this time, the growth rate of the epitaxial layer was set to about 1 µm/hour, and the growth temperature was set to 420°C.

According to observation of the surface state of each epitaxially-grown InGaAs layer in the uppermost layer by a Normanski microscope, there were no surface defects observed, and it could be verified that the surface state was extremely good.

Moreover, the haze in the surfaces of the InGaAs layers was measured by the Surfscan 6220. FIG. 4 shows a relation between the off-angle of the used InP substrates and the haze in the surfaces of the n-InGaAs layers. As shown in FIG. 4, in the case of using the InP substrates with off-angles of 0.05 to 0.20°, the haze in the surfaces of the epitaxial layers was not more than 3 ppm. Herein, since the haze in the surfaces of the InP substrates was not more than 2 ppm, the haze in the surfaces of the epitaxial layers was slightly higher than the haze in the surfaces of the substrates. However, haze of 10 ppm or less, which was required as the surface state of the epitaxial layer grown by MBE, could be achieved.

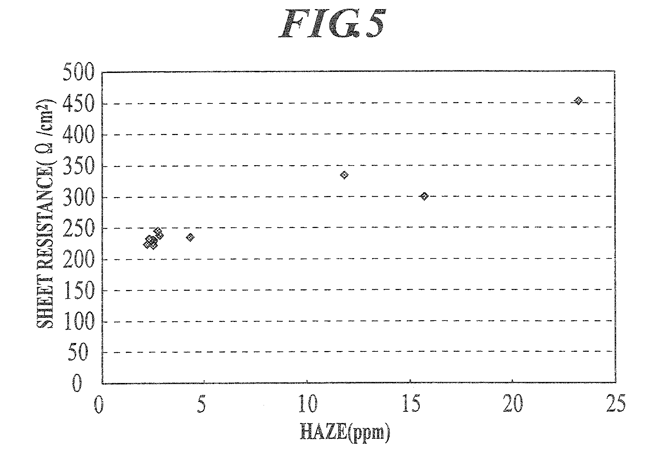

As an index of HEMT properties, sheet resistance of the epitaxial layers was measured, and results shown in FIG. 5 were obtained. The sheet resistance tended to increase as the haze in the surface of the epitaxial layer increases, and it could be thus verified that the surface state (haze) of the epitaxial layer correlated with the sheet resistance.

The results of the Examples 1 and 2 revealed that using a substrate with an off-angle of 0.05 to 0.10° and a haze of not more than 2 ppm, as ranges common to the both MOCVD and MBE, was effective on growing an epitaxial layer excellent in the surface state.

As described above, a semiconductor device in which a semiconductor layer is epitaxially grown on the substrate according to the present invention has a good surface state at the microroughness level and can be applied to an application of semiconductor devices required to be more highly integrated and sophisticated.

Hereinabove, the present invention made by the inventor was concretely described based on the embodiment. However, the present invention is not limited to the embodiment and can be modified without departing from the scope of the invention.
For example, in the above embodiments, the description is given of the example that the InGaAs layer is epitaxially grown on the InP substrate. However, the present invention can be applied in a similar manner to the case where a group III-V compound semiconductor layer other than the InGaAs layer is epitaxially grown on the InP substrate. Moreover, the present invention can be applied to not only the epitaxial growth of the group III-V compound semiconductor but also entire epitaxial growth.

Moreover, in the aforementioned embodiment, the substrates with dislocation densities of not more than 1000/cm² were used. However, the dislocation density is desirably not more than 500 /cm² since it is thought that occurrence of the surface defects can be further suppressed when the dislocation density is smaller. Moreover, the plane direction of the substrate was (100) in this embodiment, but the present invention can be applied to a substrate with a different plane direction, and setting the off-angle with respect to the plane direction of the substrate to 0.05 to 0.10° can provide the same effect. Industrial Applicability

This application is described based on the haze (scattered light intensity/incident light intensity in parts per million) measured by the Surfscan 6220 made by KLA-Tencor Corporation. However, haze measured by a haze measurement apparatus made by another corporation (for example, LS5000 made by Hitachi Electronic Engineering Corporation) can be prescribed in a similar manner. For example, the haze of the present invention is easily described with the haze measured by another haze measurement apparatus by examining a correlation between the haze measured by the Surfscan 6220 and another haze measured by the haze measurement apparatus. In such a case, the off-angle of the substrate is also set to 0.05 to 0.10°.

## Claims

1. A compound semiconductor substrate for epitaxial growth, wherein
when haze is defined as a value calculated by dividing intensity of scattered light obtained when light is incident from a predetermined light source onto a surface of a substrate, by intensity of the incident light from the light source,
the haze is not more than 2 ppm all over an effectively used area of the substrate and an off-angle with respect to a plane direction is 0.05 to 0.10°.

2. The compound semiconductor substrate as claimed in claim 1, wherein
the haze is not more than 1 ppm all over the effectively used area of the substrate.

3. The compound semiconductor substrate as claimed in claim 1 or 2, wherein
the compound semiconductor substrate is an InP substrate.

4. The compound semiconductor substrate as claimed in claim 3, wherein
a dislocation density is not more than 1000/cm².

5. The compound semiconductor substrate as claimed in claim 4, wherein
the dislocation density is not more than 500/cm².
